# EUROPEAN PATENT APPLICATION

(11) **EP 4 443 184 A1**
(43) Date of publication of application: **09.10.2024**
(21) Application number: 23305501.1
(22) Date of filing: 06.04.2023
(51) Int. Cl.: G01R 33/44, G01R 33/36, G01N 24/08

(54) **NUCLEAR QUADRUPOLE RESONANCE SPECTROMETER**

(71) Applicant: Centre National de la Recherche Scientifique, 75016 Paris (FR); Université de Lorraine, 54000 Nancy (FR)
(72) Inventor: Kachkachi, Noreddine, 54500 VAND UVRE-LÈS-NANCY (FR); Gansmuller, Axel Hans, 54520 LAXOU (FR); Rabah, Hassan, 54510 TOMBLAINE (FR); Grandclaude, Denis, 54540 VACQUEVILLE (FR)
(74) Representative: Bandpay & Greuter

(57) **Abstract**

The disclosure notably relates to a Nuclear Quadrupole Resonance (NQR) spectrometer comprising a System on Chip (SoC) Field Programmable Gate Arrays (FPGA) (240) communicatively coupled to an external memory (320). The SoC FPGA (240) is configured to perform the function of a pulse programmer (250) for producing pulse sequences. The pulse programmer is configured for reading, sequentially, instructions stored on the external memory. The SoC FPGA (240) is further configured to perform the function of an acquisition module (260) for processing an acquired analog response signal (FID) emitted by nuclei of a material to be studied and for recording the processed signal on the external memory. The NQR spectrometer offers improved portability, usability and sensitivity with respect to the state of the art.

## Description

### TECHNICAL FIELD

The disclosure relates to the field of the Nuclear Quadrupole Resonance (NQR) instrumentation, and more specifically to a NQR spectrometer and a computer program for such a NQR spectrometer.

### BACKGROUND

Nuclear Quadrupole Resonance (NQR) is a radio frequency (RF) spectroscopy of solids used in non-invasive chemical analysis for products containing Quadrupolar Nuclei (e.g. ¹⁴N, ³⁵Cl) such as narcotics, explosives and drugs. It is also of great interest for the structural study of crystals.

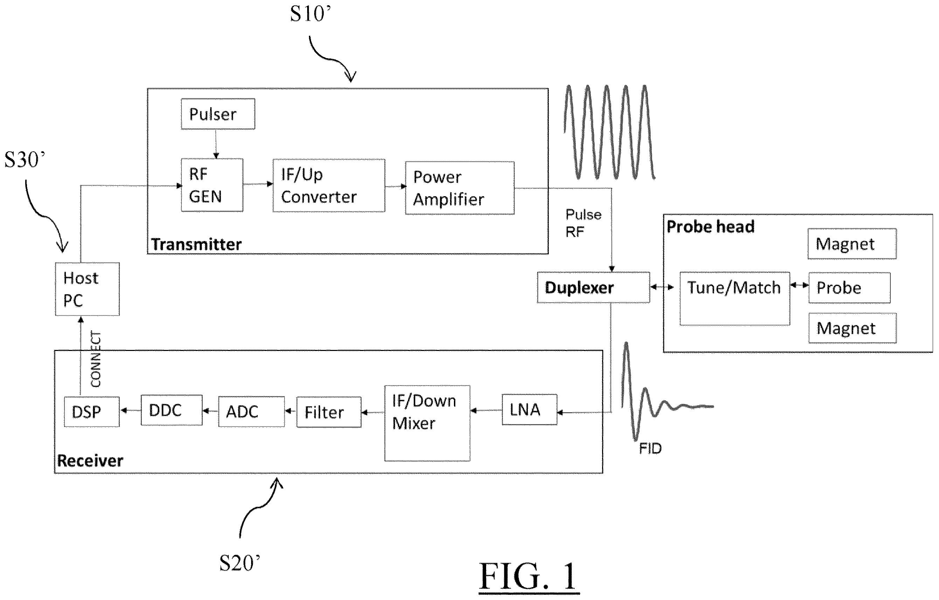

In recent years, different spectrometers capable of performing NQR spectroscopy have been developed. With reference to FIG. 1, the functioning of existing NQR spectrometers is now discussed. A NQR spectrometer is generally configured to perform the function of a pulse programmer S10' for producing pulse sequences toward a nuclei of the material to be studied. For each scan of the NQR spectrometer, the pulse programmer S10' configures an excitation module to emit, during an emission phase, RF (Radio frequency) excitation pulses toward the atomic nuclei of a material to be studied. After this emission phase, the NQR spectrometer is configured to perform the function of an acquisition module S20' for performing, during a reception phase starting after the end of the emission phase, an acquisition of the response signal emitted by the nuclei of the material to be studied. As known in the art, the response signal, also referred to as the Free Induction Decay signal (FID), emitted by the atomic nuclei contains characteristic frequencies that are usually referenced with a frequency offset *Δvᵢ* with respect to the RF excitation pulses. These frequency offsets *Δvᵢ* allow deducing structural properties of the studied material. The purpose of a NQR spectrometer is therefore to determine these frequency offsets *Δvᵢ* in order to inform on the material under investigation.

The main limitations of existing NQR spectrometers are still the lack of portability, usability and sensitivity. Indeed, they must be connected to a host station in order to transmit S30' the measurement data for recording on the host station. For this reason, they do not offer the ability to perform measurements away from the host station, which limits the portability and usability of existing NQR spectrometers. Additionally, since the number of measurement points increases with the spectral resolution and acquisition frequency range, the amount of memory required for recording increases as well. Memory limitations may therefore also impact the accuracy of the measurements. Moreover, memory limitations may also limit the amount of instructions that can be stored on the NQR spectrometers. Therefore, memory constraints may limit the stand-alone measurement time of current spectrometers.

Within this context, there is therefore a need for NQR spectrometer with optimized memory management to improve portability, usability and sensitivity.

### SUMMARY

It is therefore provided a Nuclear Quadrupole Resonance (NQR) spectrometer comprising a System on Chip (SoC) Field Programmable Gate Arrays (FPGA) communicatively coupled to an external memory. The FPGA SoC is configured to perform the function of a pulse programmer for producing pulse sequences. The pulse programmer is configured for reading, sequentially, instructions stored on the external memory. The FPGA SoC is further configured to perform the function of an acquisition module for processing an acquired analog response signal (FID) emitted by nuclei of a material to be studied and for recording the processed signal on the external memory. The acquired analog response signal contains one or more frequencies each including a respective frequency offset *Δvᵢ* with respect to the RF excitation pulses.

The NQR spectrometer may comprise one or more of the following:
- The processing of the acquired analog response signal comprises filtering, denoising and/or decimating the acquired analog response signal;
- The FPGA is configured to repeat the execution of the functions of the pulse programmer and of the acquisition module cyclically. Each repetition of the recording of the processed signal comprising:
   ∘ retrieving one or more previously accumulated FIDs that have been stored temporarily in the external memory;
   ∘ accumulating the processed signal with the retrieved one or more previously accumulated FIDs; and
   ∘ storing the result of the accumulation in the external memory;
- The produced pulse sequences have phases. The phases of the produced pulse sequences varying cyclically at each repetition. The accumulating of the processed signal with the one or more previously accumulated FIDs comprises a subtraction or an addition of the processed signal with the one or more previously accumulated FIDs according to the phase variation;
- The NQR spectrometer is configured to, after each repetition, send the result of the accumulation to a post-processing unit;
- The NQR spectrometer is configured to send the result of the last accumulation performed at the end of an experiment to a post-processing unit;
- The FPGA is further configured to perform the function of a Direct Digital Synthesizer (DDS) for generating the RF excitation pulses that stimulates the nuclei of the material to be studied;
- The pulse programmer has a pulse width resolution equal to or larger than 8 nanoseconds;
- The external memory is a DDR memory;
- The external memory has a storage capacity equal to or larger than 1 gigabit;
- The instructions are current experiment related 128-bits coded instructions words. The instructions are stored on a dedicated zone of the external memory;
- The processing of the acquired analog response signal further includes:
   ∘ digital frequency shifting the acquired analog response signal by digitally multiplying the acquired analog response signal by an RF signal so as to obtain a signal centered around a fixed intermediate carrier frequency (IF) containing one or more frequencies with the one or more offsets equal to *Δvᵢ* after digital band-pass filtering;
   ∘ digitally down converting (310) the centered signal so as to obtain a complex demodulated signal having one or more frequencies corresponding to the one or more offsets *Δvᵢ*; and/or
- The spectrometer is coupled to an ultra-broad band probe, with a detection spectral width equal to an initial spectral width before decimation corresponding to an interval [0, F,/2], wherein Fₛ is a sampling frequency of the analog-to-digital conversion.

It is further provided a computer program comprising instructions which, when the program is executed by the NQR spectrometer, cause the NQR spectrometer to carry out the functions of the pulse programmer.

The NQR spectrometer may be configured to read the instructions of the computer program stored in the computer readable storage medium so as to carry out the functions of the pulse programmer and the acquisition module.

### BRIEF DESCRIPTION OF THE DRAWINGS

Non-limiting examples will now be described in reference to the accompanying drawings, where:
- FIG. 1 illustrates a general synoptic diagram of existing NQR spectrometers;
- FIG.s 2 to 4 illustrate the architecture of the NQR spectrometer;
- FIG. 5 illustrates an example of test environment of the FPGA; and
- FIG. 6 shows an example of spectrum obtained by the NQR spectrometer.

### DETAILED DESCRIPTION

It is therefore provided a NQR spectrometer comprising a SoC FPGA communicatively coupled to an external memory. The FPGA is configured to perform the function of a pulse programmer for producing pulse sequences. The pulse programmer is configured for reading, sequentially, instructions stored on the external memory. The SoC FPGA is further configured to perform the function of an acquisition module for processing an acquired analog response signal (FID) emitted by atomic nuclei of a material to be studied and for recording the processed signal on the external memory. The acquired analog response signal contains one or more (e.g., characteristic) frequencies each including a respective frequency offset *Δvᵢ* with respect to the RF excitation pulse sequence.

The NQR spectrometer offers improved portability, usability and sensitivity with respect to the state of the art.

Notably, the storage of the processed signal on the external memory improves the portability and usability of the spectrometer. Indeed, it allows not to be constrained by storage limitation (e.g., of an internal memory of the SoC FPGA) which removes the need to be regularly connected to a host station in order to transmit the measurement data for recording on the host station. The NQR spectrometer thus offers the ability to perform long measurements in stand-alone, away from the host station. In particular, the NQR spectrometer allows measurements to be recorded with a large number of measurement points, thus allowing measurements to be made with high accuracy. In addition to this, locally storing and pre- processing the acquired FID can be crucial for acquisition over a large frequency window where the FID contains a large number of points (e.g. up to 1 Million points), and the time given between two scans is not sufficient for transferring the FID to the Host. Moreover, the number of instructions recorded in the memory is also no longer limited by the internal memory of the SoC FPGA.

Furthermore, the low power functionality of the SoC FPGA makes it possible to perform in-field measurements using a small battery, thus increasing portability. Additionally, digitally implementing and integrating on SoC FPGA the functions of pulse programmer and acquisition module allows processing a high-end acquisition pipe with embedded digital signal processing and de-noising techniques. This enhances the user experience and increases drastically the spectrometer's performances, in particular, the pulse width resolution of the affordable NQR experiment, as well as the sensitivity and the signal to noise ratio.

### Description of SoC FPGA

The NQR spectrometer comprises the SoC FPGA communicatively coupled to the external memory and may comprise various peripherals such as Analog/Digital converters (ADC, DAC). The SoC FPGA is an integrated circuit which may be configured (e.g., by a designer after manufacturing) to execute the functions of the pulse programmer and of the acquisition module. The type of SoC FPGA used here is a programmable SoC, which integrates in a single chip, a processing system and programmable logic. The processing system includes, an embedded application processor, an on chip memory, DMA controllers, a configurable interconnect, external memory interfaces and a wide range of peripherals interfaces. The programmable logic part, is composed of a matrix of configurable logic blocks (CLBs), embedded Block RAMs, DSP Blocks, JTAG interface, PCIe Block, Serial transceivers and ADCs.

The external memory is a memory storage discrete component typically and SDRAM like a DDR2 or a DDR3 (Double Data Rate) accessed by the FPGA via a 16-bits or 32-bits interfaces and enabling up to 1GB of address spacing. The memory is a component that is used to store information for immediate use in the NQR spectrometer. The memory may have a storage capacity to store more than 1 million instructions and an FID of up to 26 Seconds (e.g. for a typical detection frequency range of 40kHz).

The FPGA is communicatively coupled to the external memory. Communicatively coupled means that the FPGA and the external memory may exchange data (such as instructions or acquisition points of signals). For example, the FPGA may be configured to record data on the external memory and the recorded data may include one or more processed signals. Alternatively, or additionally, the FPGA may be configured to retrieve data recorded on the external memory, such as one or more processed signals previously recorded on the external memory. The FPGA may also be configured to read instructions stored on the external memory (e.g., during the execution of the pulse programmer function).

### Description of the pulse programmer

The pulse programmer function is for producing one or more pulse sequences. The producing of the pulse sequences may comprise, for each pulse sequence, generating an analog signal corresponding to the pulse sequence and instructing an emitting component (e.g., a probe) to emit the generated analog signal (e.g., after an amplification of the generated analog signal). The emission of the produced pulse sequences may be directed to the material to be studied. The material may be any type of material to be studied. For example, the material may be a sensitive product such as a narcotic, an explosive or a drug.

The one or more pulse sequences may be emitted sequentially in time, i.e., one after the other (so as to follow each other). The pulse sequences may be produced after a user input (e.g., after that a user perform a user input on the NQR spectrometer). The FPGA may be configured to receive the user input (e.g., that includes parameters for the pulse sequences) and, then, to start producing the pulse sequences (e.g., after the detection of a press on a start button by the user). The produced elements inside the pulse sequences have a duration between 8 ns and 4679,53 year and/or a phase between 0 degree and 360 degrees.

Each produced pulse sequence may comprise one or more individual pulses. The individual pulse(s) may each have a predetermined duration and may be spaced from each other with a time spacing. For example, each pulse may have a pulse width equal to or larger than 8 nanoseconds. The time spacing between two successive pulses may be equal to or larger than 8 nanoseconds .

In examples, the producing of one or more (e.g., all) of the pulse sequences may comprise a phase-cycling. In that case, for each of these pulse sequences, the phases of the pulses may vary cyclically. For example, the pulses may each have a respective phase, and the phases of the pulses may correspond to a subdivision of a total phase amplitude (i.e., 360 degrees). For example, each given pulse may have a respective phase that includes a phase increment with respect to a prior pulse (i.e., a priori pulse that is produced prior to the given pulse). In that case, the phase increment may be any divisor of the total phase amplitude (e.g., 45, 90 or 180 degrees). The phase of the first pulse may be equal to 0 degree.

The pulse programmer is configured for reading, sequentially, instructions stored on the external memory. For example, the external memory may store a sequence of instructions for each pulse sequence. The instructions may be current experiment related 128-bits coded instructions words. The instructions may be stored on a dedicated zone of the external memory. The producing of each pulse sequence may comprise reading, sequentially on the external memory, the sequence of instructions stored for the pulse sequence. The duration of a pulse, which is the duration of the execution of a pulse instruction, is contained in the MSB 64-bits of the 128-bits corresponding instruction word. The instructions may then include the time duration of the instructions (e.g., elapsed time between the start of the pulse and the end of the pulse) and fields defining parameters of the production of the pulse (e.g., phase, frequency and/or amplitude). These parameters (e.g., phase, frequency and/or amplitude) may also be configured directly by software through registers settings.

### Description of the acquisition module

The acquisition module function comprises the processing the acquired analog response signal. The response signal may be emitted by the nuclei of the material to be studied in response to the produced pulse sequences. The acquired analog response signal may contain a frequency *vᵢ* with an offset *Δvᵢ* with respect to the RF excitation pulse sequence. Alternatively, the acquired analog response signal may contain several frequencies *vᵢ* with offsets *Δvᵢ* with respect to the RF excitation pulse sequence. The acquisition module function comprises the acquisition of the analog response signal (e.g., by a probe coupled to the NQR spectrometer).

The acquisition may comprise an analog-to-digital conversion of the analog response signal. The result of the analog-to-digital conversion may be a set of digitally coded (e.g., 14-bits wide) discrete acquisition samples. The number of acquisition points per signal may exceed one million point. This set of acquisition points is the acquired analog response signal which is processed by the FPGA. The processing may comprise a pre-processing of the acquired response signal into a format that may be processed by the vendor's digital IPs (Filters, CIC,...) (e.g., including a 14 bits offset binary to inverted 16 bits signed conversion).

The processing of the acquired response signal may further comprise demodulating filtering and decimating the acquired response signal. The filtering may comprise removing, and/or reducing one or more portions of the spectral width represented in the signal. A decimation with rate M consists in reducing the sample rate by selecting only a sample out of M input samples of the digitalized signal, which allows reducing the memory space used for recording the processed signal. Alternatively, or additionally, the processing of the acquired response signal may comprise denoising the acquired response signal. The denoising may comprise removing noise from the signal. The denoising allows maintaining the same amount of memory space while increasing the accuracy of the recorded signal.

In examples, the FPGA may be configured to repeat the execution of the functions of the pulse programmer and of the acquisition module cyclically. Each cycle of repetition may comprise the producing of one or more pulse sequences and an execution of the acquisition module function for the signal emitted by the nuclei in response to the produced pulse sequence. The SoC FPGA may thus be configured to repeat the acquisition module function for each produced pulse sequence. After the emission of each produced pulse sequence (excitation phase), the nuclei of the material to be studied emit a response signal, also referred to as the Free Induction Decay signal (FID), in response to the excitation by the produced pulse sequence. The SoC FPGA may therefore execute the acquisition module function (e.g., after a waiting time) for processing the response signal emitted by the nuclei (acquisition phase) and recording the processed signal on the external memory. Each pulse sequence produced during the execution of the pulse programmer function may therefore be followed by an execution of the acquisition module function. The SoC FPGA may be configured to repeat the execution of the acquisition module function after each produced pulse sequence.

### Signal accumulation procedure

Each repetition of the acquisition module function may comprise the repetition of the recording of the processed signal. Each repetition of the recording of the processed signal may comprise retrieving one or more previously accumulated FIDs that have been stored temporarily in the external memory. The one or more previously accumulated FIDs may have been stored temporarily in the external memory during a previous execution of the acquisition module function. After the retrieving, the recording of the processed signal may comprise accumulating the processed signal with the retrieved one or more previously accumulated FIDs. For example, the accumulating of the processed signal with the retrieved previously accumulated FIDs may comprise averaging, summing or subtracting the processed signal and the retrieved FIDs (e.g., the acquisition points of these signals). After the accumulation, the recording of the processed signal may comprise storing the result of the accumulation in the external memory. The result of the accumulation may be the signal resulting from the averaging, the summing or the subtracting of the processed signal and of the retrieved previously accumulated FIDs.

The accumulation of the processed signal with one or more previously accumulated FIDs participates to the reduction of memory space while maintaining a high level of accuracy. Indeed, the accumulation avoids duplication of the signals recorded in the memory and increases the precision of the accumulated signal. Moreover, this on-the-fly accumulation and storage by the SoC FPGA of the acquired signal inside the external memory enhances portability by minimizing the data exchange by the spectrometer as the sending of the accumulated detected signal may only be performed at the very end of the experiment.

In examples, when the producing of the pulse sequences comprises a phase-cycling, the accumulating of the processed signal with the one or more previously accumulated FIDs may comprise a subtraction or an addition of the processed signal with the one or more previously accumulated FIDs according to the phase variation.

For example, the total phase amplitude (i.e., 360 degrees) may be subdivided in two, and the pulse programmer function may produce the pulse sequences having a first phase (e.g., 0 degree) corresponding to the first subdivision and a second phase (e.g., 180 degrees) corresponding to the second subdivision. For the first phase, the accumulating may comprise an addition of the processed signal with the one or more previously accumulated FIDs (i.e., with a set of zero values for the first cycle or with the last accumulated signal recorded after). For the second phase, the accumulating may comprise a subtraction of the processed signal from the accumulated signal recorded for the first phase.

In another example, the total phase amplitude (i.e., 360 degrees) may be subdivided in four (a first phase of 0 degree, a second phase of 90 degrees, a third phase of 180 degrees and a fourth phase of 270 degrees). In that case, the accumulating may be different for the real and imaginary parts of the acquired response signal. The processing of each signal may comprise the demodulation of the signal, thereby dissociating the real and imaginary parts of the signal.

For the first phase (0 degree), the accumulating may comprise, for the real and imaginary parts of the signal, an addition of the processed signal with the one or more previously accumulated FIDs (i.e., with a set of zero values for the first cycle or with the last accumulated signal recorded after). For the second phase (90 degrees), the accumulating may comprise, for the real part, an addition of the imaginary part of the current processed signal with the real part of the accumulated signal recorded for the first phase. For the imaginary part, the accumulating may comprise a subtraction of the real part of the current processed signal from the imaginary part of the accumulated signal recorded for the first phase. For the third phase (180 degree), the accumulating may comprise, for the real part, a subtraction of the real part of the current processed signal from the real part of the accumulated signal recorded for the second phase. For the imaginary part, the accumulating may comprise a subtraction of the imaginary part of the current processed signal from the imaginary part of the accumulated signal recorded for the second phase. For the fourth phase (270 degree), the accumulating may comprise, for the real part, a subtraction of the imaginary part of the current processed signal from the real part of the accumulated signal recorded for the third phase. For the imaginary part, the accumulating may comprise an addition of the real part of the current processed signal with the imaginary part of the accumulated signal recorded for the third phase.

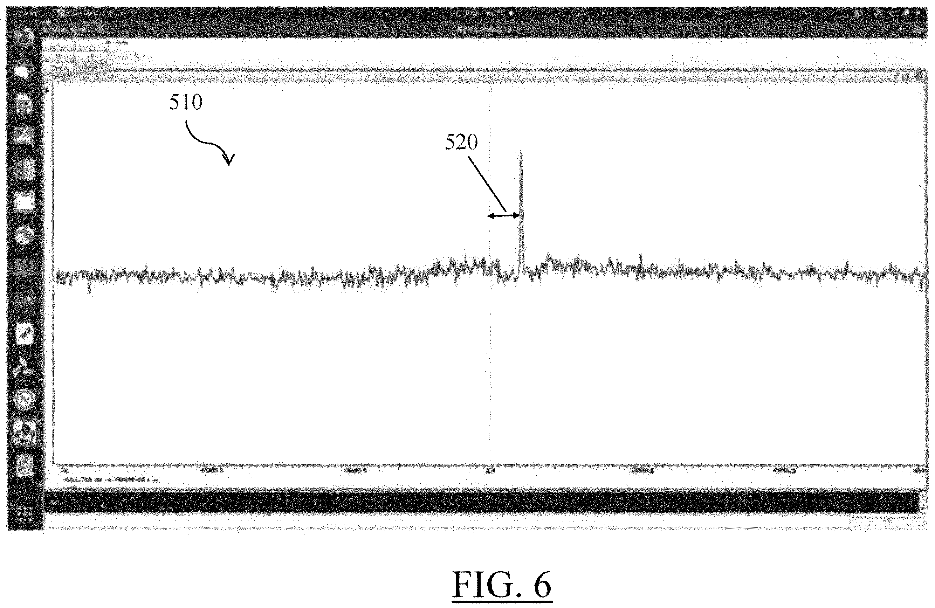

The spectrometer provided here offers two acquisition modes:
In the "scan per scan transfer" mode, the NQR spectrometer is configured to, after each repetition, send the result of the accumulation to a post-processing unit. For example, the NQR spectrometer may be connected to the post-processing unit. The post-processing unit may be a host station. The post-processing unit may comprise a display and may be configured to display the result of the accumulation (e.g., after a post-processing of the result). The display may comprise a graph (e.g., such as the graph showed in FIG. 6) on which the user may read the signal frequency *Δvᵢ*. The post-processing unit may update the display as results are sent to it from the NQR spectrometer.

In the "single transfer" mode , the NQR spectrometer may be configured to send the result of the last accumulation performed at the very end of an experiment to a post-processing unit. In that case, the NQR spectrometer may only send the result of the last accumulation. The post processing may be configured for displaying the result of the last accumulation sent by the NQR spectrometer. It allows reducing the amount of data exchanged between the NQR spectrometer and the post-processing unit, which is particularly useful when the recorded signal includes many acquisition points (as in the case of the broad-band detection, i.e. detection over a large frequency range).

### Description of the Direct Digital Synthesizer (DDS) function

In examples, the SoC FPGA is further configured to perform the function of a DDS for generating the RF excitation pulses that excites the nuclei of the material to be studied. The generated RF pulses may be controlled in frequency, in phase and in amplitude. The frequency value is set by configuring corresponding registers that are sent to the configuration input of the DDS. The phase of the generated pulse is controlled by phase fields contained in the pulse programmer instructions, which are connected to phase configuration inputs of the DDS. Finally, the amplitude of the output pulse is controlled by a divider.

In examples, the processing of the acquired analog response signal may further include digital frequency shifting the acquired analog response signal. The shifting may comprise up-converting the frequency (i.e., increasing the frequency) of the acquired analog response signal or down-converting (i.e., decreasing the frequency) the frequency of the acquired analog response signal. The shifting may comprise multiplying the acquired analog response signal by a local RF oscillating signal. The frequency of the local RF oscillating signal may be the sum of the RF pulse frequency and a fixed intermediate frequency (IF). After the multiplication, the resulting signal may have been centered around the fixed intermediate carrier frequency (IF) with typical frequency offsets equal to *Δvᵢ*, after digital band-pass filtering. The spectrometer may be coupled with a standard probe which can be tuned to transmit and receive signals in a frequency range typically comprised between -20kHz and +20 kHz and centered around the expected response signal frequencies. In that case, the spectral width of the recorded signal may therefore be comprised between -20kHz and +20kHz. This narrow-band recording allows detecting frequency offsets *Δvᵢ* comprised in this spectral width [-20kHz; +20kHz].

For each response signal frequency *Δvᵢ*, the multiplication may give a signal having two frequency components: a first component with a frequency of *FI* + 2 ∗ *v_{RF}* + *Δvᵢ* and a second component with a frequency of *FI* - *Δvᵢ*, wherein *v_{RF}* is the frequency of the pulse sequence, *Δvᵢ* is the offset and *FI* is the intermediate carrier frequency. The processing may comprise removing the first component of the signal by filtering the resulting signal. After the shifting, the processing of the acquired analog response signal may further include digitally down converting the centered signal so as to obtain a complex demodulated signal having a frequency corresponding to the offset *Δvᵢ* . The digitally down converting may comprise demodulating the centered signal so as to obtaining the real and imaginary parts of the centered signal. The offset *Δvᵢ* may be obtained from the real and imaginary parts of the centered signal. The objective is to reproduce the same mechanism used by the classical analog I/Q demodulation which is performed here digitally on the digital signal obtained at the output of the multiplier, i.e.; after the shifting step. Indeed, after I/Q demodulation the resultant complex signal would be cos(2π ×( *FI - Δvᵢ* )× t) ^{∗} cos(2π × FI × t) + j ^{∗} cos(2π ×( *FI* - *Δvᵢ* )× t) ^{∗} sin (2π × FI × t). The in-phase, I, signal is then equal to cos(2π ×( *FI* - *Δvᵢ* )× t) ^{∗} cos(2π × FI × t), the quadrature signal, Q, is equal to cos(2π ×( *FI* - *Δvᵢ* )× t) ^{∗} sin (2π × FI × t). Each of the complex components contains two frequencies 2 ∗ *FI* - *Δvᵢ* and -*Δvᵢ.* after low-pass filtering the offset *Δvᵢ* is obtained. The low-pass filter used here is integrated in the CIC filter.

In order to simplify in VHDL code the digital multiplication by cos(2π × FI × t) and sin(2π × FI × t), the intermediate frequency FI is chosen to be exactly the fourth of the sampling rate. For this reason, the values of cos(2π × FI × t) and sin(2π × FI × t) at the sampling instants reduce to the simple integer values which are 1, 0, -1, 0 and 0, 1, 0, -1 respectively. The generation of the digital I and Q, which is the function of the DDC (Digital Down converter) VHDL block, is then simplified to a simple multiplexing scheme by redirecting the digital incoming sample, which is cos(2π ×( *FI* - *Δvᵢ* )× t), either to the I channel or to the Q channel one after the other with sign inversion. This multiplexing mechanism is equivalent to the classical analog formula presented in the beginning (i.e.; cos(2π ×( *FI* - *Δvᵢ* )× t) ^{∗} cos(2π × FI × t) + j ^{∗} cos(2π ×( *FI - Δvᵢ* )× t) ^{∗} sin (2π × FI × t))

In examples, the spectrometer may be coupled with an ultra-broad band probe (i.e., having a band equal or higher than 1 MHz). In that case, the acquisition of the analog response signal may comprise analog-to-digital converting the response signal. The recorded signal may have a spectral width substantially equal to an original spectral width corresponding to an interval [0, Fs/2], wherein Fs is a sampling frequency of the analog-to-digital conversion. In other words, the acquired signal may be directly recorded on the memory (i.e., without frequency shifting, nor demodulation, nor decimation or with very low decimation rate). The presence of the external memory allows this broad-band recording of the signal. This broad-band recording allows detecting very dispersed frequencies on the spectrum at the same time (for example several frequencies excited by multiple RF channel pulses, or from a wide band pulse).

### Implementation of the NQR spectrometer

With reference to FIG.s 2 to 6, examples of implementation of the NQR spectrometer are now discussed.

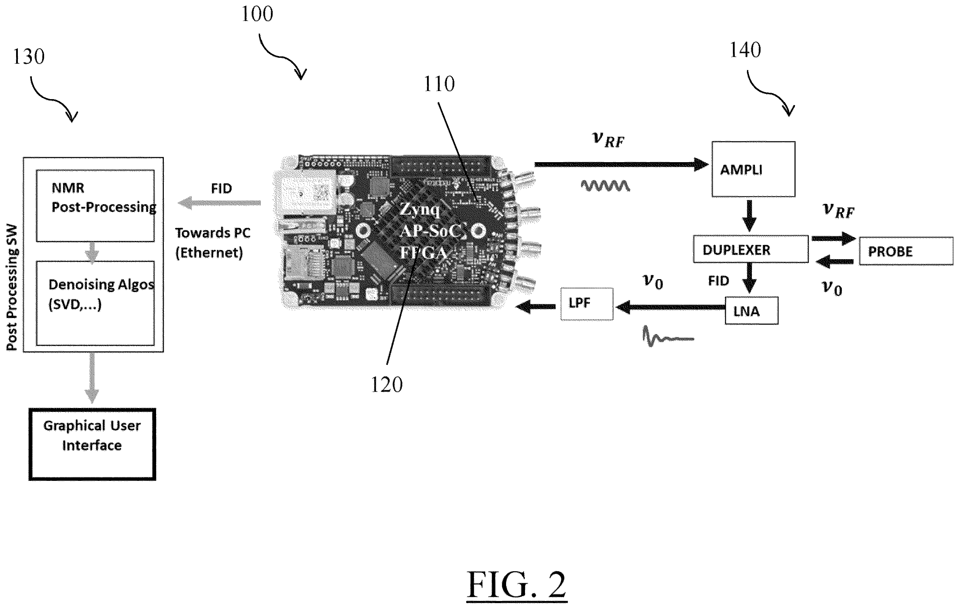

FIG. 2 shows the NQR spectrometer 100 which comprises an electronic board 110 (e.g., Redpitaya) and is intended for typical NQR applications and experiments such as detection and analysis of products containing quadrupolar nuclei (e.g. ¹⁴N or ³⁵Cl) like explosives, pharmaceuticals or functional-materials. The NQR spectrometer 100 embedded system is based on a SoC , which is implemented on a FPGA 120 (e.g., from the Xilinx Zynq-7000 series family). The SoC FPGA 120 is configured to perform the function of a pulse programmer for producing one or more pulse sequences. The pulse programmer is configured for reading, sequentially, instructions stored on the external memory. The pulse programmer function may be a high pulse width resolution pulser (pulse width down to 8 ns) and may be written in VHDL (Hardware Description Language). The SoC FPGA 120 is further configured to perform the function of a transmitter. The transmitter function may comprise a Direct Digital Synthesizer (DDS) function controlled in frequency, phase and amplitude which allows to make elaborate NQR experiments (Cyclops phase cycling for example). The DDS function may comprise generating shaped RF excitation pulses that stimulates the nuclei of the material to be studied. The FPGA 120 is configured to perform the function of an acquisition module for processing an acquired analog response signal (FID) emitted by nuclei of a material to be studied. The acquisition module may be a digital acquisition module with intermediate frequency and based on DMA (Direct Memory Access), digital filters and a hardware debug module. The architecture of the SoC FPGA FPGA 120 includes a high-level backbone that consists of an AXI4 interconnect, a dual core processor ARM9 processor and an external DDR3 memory.

The use of the DDR memory external to the FPGA 120 to store the pulser instructions, as well as the NMR/NQR signal, offers an important advantage that allows to increase considerably the duration of the NQR/NMR experiment prior to transfer to host station as well as the size of the FID (Free Induction Decay). Moreover, the use of the DMA in the pulser and acquisition architecture allows to increase the operating speed and to increase the bandwidth, considering that the access to the FID is done by a system clock (166 MHz) faster than the maximum clock of the ADC which is 125 MHz. This architecture also guarantees the perfect synchronization during the execution of the pulser instructions, which is an improvement because it reduces the risk of dead time or waiting time between the instructions.

This architecture includes the use of high speed and Clock-Domain Crossing design techniques and tools such as DMAs, FIFOs (first-in first-out) and clock domain converters. The NQR spectrometer uses these utility Ips (DMAs, Clock-Domain Converters and FIFOs) as building blocks in the SoC FPGA.

The operating power requirement is very low (the NQR spectrometer may produce a detection even with 2W), which allows a high portability and miniaturization facilitating its use in outdoor applications (landmine detection for example). With the utility options (e.g. offered by the Redpitaya board such as embedded Linux or Ethernet connection) the NQR spectrometer becomes a connected object, controllable and usable remotely. The NQR spectrometer 100 may be connected with a post-processing unit 130 (e.g., such as a computer system via the Ethernet connection). The NQR spectrometer 100 may be configured to, after each repetition, send the result of the accumulation to the post-processing unit. Alternatively or additionally, the NQR spectrometer 100 may be configured to send the result of the last accumulation performed at the end of an experiment to the post-processing unit.

In addition, the use of the SoC FPGA 120 makes the NQR spectrometer flexible and adaptable. The re-configurability of the SoC FPGA allows to provide hardware (bitstream) and software configurations to adapt the architecture and the signal processing according to the needs. These configuration data may be loaded or plugged in remotely and on demand.

Furthermore, the SoC FPGA 120 (e.g., from the Zynq-7000 family) is a complex system that may be based on very advanced sub-micron VLSI technologies (28 nm). The SoC FPGA gathers on a single chip programmable logic with embedded microprocessors (ARM), which provides a platform for hardware and software development and high-level design methodologies and flows. The NQR spectrometer 100 may comprise another electronic board 140 which may be interfaced with the board 110 comprising the SoC FPGA 120. This additional electronic board 140 may group other hardware functionalities, for example a Front-End part (Probe, tuning system, Duplexers) as well as a power amplifier. The NQR spectrometer 120 may thus evolve into a fully integrated miniature spectrometer on a single electronic board that can be designed by a single manufacturer.

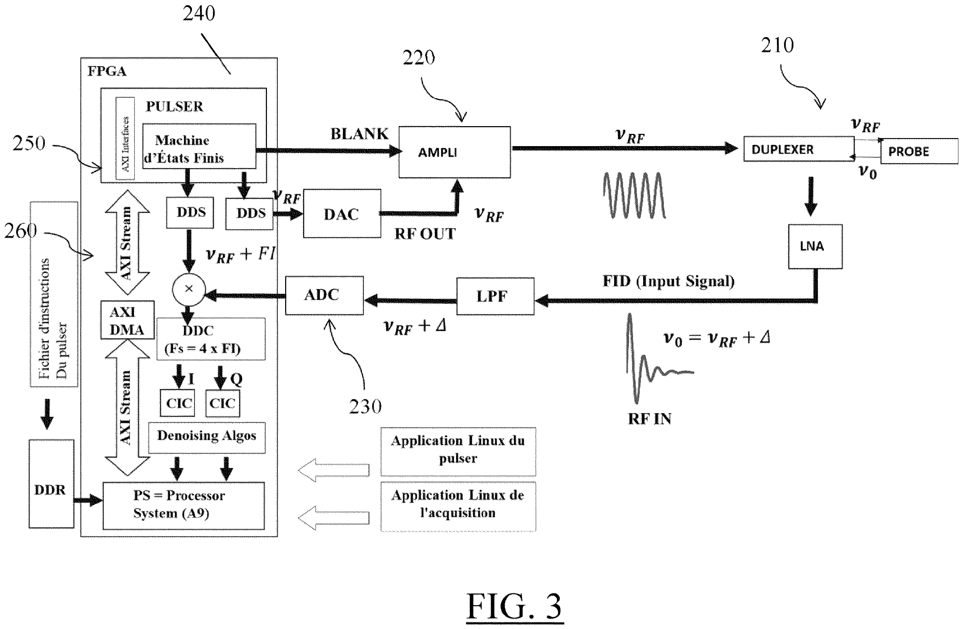

FIG. 3 illustrates the architecture of the NQR spectrometer. The functionalities of the spectrometer, namely pulse programmer 250, excitation 220, 210 and acquisition 260, are implemented on the SoC FPGA 240.

The NQR spectrometer is composed for the hardware part of an analog Front-End 210 (Probe, Duplexer, LNA), a power amplifier 220, an electronic board 230 which contains the ADC, DAC converters as well as the FPGA 240 (e.g., of the Zynq-7000 family from Xilinx). In addition to the hardware, the NQR spectrometer contains Linux applications (Pulser application 250 ) that run on the CPU embedded in the SoC FPGA. These applications are used to drive the pulser and the other parts of the spectrometer. The on-board system of the NQR spectrometer (FPGA and Linux applications) communicates with the user through an interfacing software (for example written in JAVA). Through the menu (GUI) of the interfacing software, the user may define a desired sequence for the NQR experiment as well as the various parameters of the experiment such as the excitation frequency or the number of acquisition points. The NQR spectrometer may be configured to generate two characteristic files of the experiment in a format specific to the NQR spectrometer. Then, the NQR spectrometer may be configured to compile these two files by a program in C that transforms them into a text file that contains all the instructions that are specific the NQR spectrometer and that will be executed by the pulse programmer one after the other throughout the manipulation. These instructions are coded in hexadecimal format on 128 bits. Each instruction word comprises a field that contains the instruction code (for example 0x07 for the instruction "ACQUISITION", 0x01 for the instruction "PULSE" or 0x10 for the instruction "DELAY"). Each instruction word may comprise other fields containing other parameters of the instruction such as for example pulse duration, phases or delay value. Then, the NQR spectrometer may be configured to store these instructions in the external DDR memory of the SoC FPGA.

Among the performances of the pulser 250, (e.g. coded in VHDL), there is the very high event width resolution, or minimum event delay, which is 8 ns and corresponds to one clock cycle, since the pulse programmer works at 125 MHz. The other important performance is also the minimum pulse duration which is 8 ns too. The other advantage of the pulse programmer is that it works with instructions previously stored in the external DDR memory, which considerably increases the affordable number of instructions (the memory management may afford at least one million instructions).

When the user starts the NQR manipulation, the pulse programmer function 250 includes a search of the instructions stored in the DDR via a DMA (Direct Memory Access) and a storage of a part of these instructions in a buffer memory (e.g., a FIFO). The pulse programmer function includes then (for example via a state machine) an execution of the different instructions and a generation of control outputs to control the experiment. Indeed, for a given manipulation, the pulse programmer function starts by generating a "PULSE" instruction, which generates "Pulse", "Blank" and "Damp" signals which control the pulse duration and which modulate the RF signal emitted by the DDS during the excitation. An application of the pulse programmer function programs, among other things, the value of the excitation frequency (*v_{RF}*) whose duration is controlled by the "Pulse" signal from the pulser. The phase of the carrier is also controlled by the phase signals from the pulser. These phase signals directly control the phase of the DDS in the FPGA.

The carrier amplitude is controlled by the Linux application of the pulser 250 which programs the amplitude division that is performed by the FPGA. The "Blank" signal generated by the pulser is used to guarantee that the power amplifier is only active during the excitation time.

The NQR spectrometer is configured to amplify the well-conditioned and parameterized RF signal in frequency, phase and duration and then send this amplified signal to the probe to irradiate the nucleus to be studied. Just after the RF pulse is emitted, the pulser 250 enters the "DAMP" state in order to generate the "Damp" signal which may be used to untune the probe and thus reduce the ringing effect. After the excitation phase and during its return to equilibrium, the atomic nuclei of the material to be studied may emit an NMR/NQR signal called FID (Free Induction Decay) containing frequencies (*v*_{0*i*}), called the resonance frequencies, that slightly differ from the carrier (*v_{RF}*) by frequency offsets *Δvᵢ* . Just after the excitation and damping phase, the NQR spectrometer begins the execution of the acquisition module function 260, which serves to detect the NMR/NQR signal which has a frequency of *v*_{0*i*} = *v_{RF}* + *Δvᵢ*. The triggering of the acquisition 260 is cadenced by the pulser 250 which generates the signal "Trigger" which gives the moment of starting of the acquisition 260. The finite state machine of the pulser 260 enters the "TRIGGER" state (a state that lasts one clock cycle) just before the "ACQUISITION" state. The "TRIGGER" state is used to generate the "Trigger" flag which gives the acquisition module 260 the order to start the acquisition after having passed through a Trigger module which is used to process and select the "Trigger" signal according to its origin (Rising/Falling edge of one of the RF input voices, Pulser or Software). The pulser 250 contains a register where it stores the current scan number. This scan number register is used (Monitored) by the interfacing software to restart the acquisition of a new FID as long as the current scan number is less than the number of scans programmed by the user. The NMR/NQR signal emitted by the nuclei through the probe is first amplified by a low noise amplifier (LNA), then it is filtered by a low pass analog filter (LPF).

After these first pre-processings, the NQR spectrometer is configured to digitize the signal by an analog-to-digital converter (ADC) (e.g., with a sampling frequency of 125 MS/S). Once the signal is digitized, the NQR spectrometer is configured to send the digitized signal to the FPGA (see FIG. 3), and the FPGA executes the acquisition module function 260 on this digitized signal. The acquisition module function 260 comprises a digital frequency shifting (frequency translation) of the digitized signal first to an intermediate frequency by multiplying the digitized signal by an RF signal of frequency *v_{RF}* + *IF,* in order to obtain a signal with a frequency of *IF* - *Δvᵢ*. The objective is to bring the acquired signal, whose frequency is variable, around a fixed intermediate carrier frequency (*IF*). This improves the recording of the processed signal. Indeed, it allows the frequency of the carrier (IF) to be equal to a quarter of the sampling frequency which simplifies the quadrature demodulation performed in the DDC (Digital Down Converter). The frequency of the carrier (IF) may be fixed to be equal to a quarter of the sampling frequency because the sampling frequency is fixed. The NQR spectrometer allows the increase of the frequency, the multiplication by the second DDS to obtain the new fixed carrier, to be done at the level of the digital part (i.e., inside the FPGA).

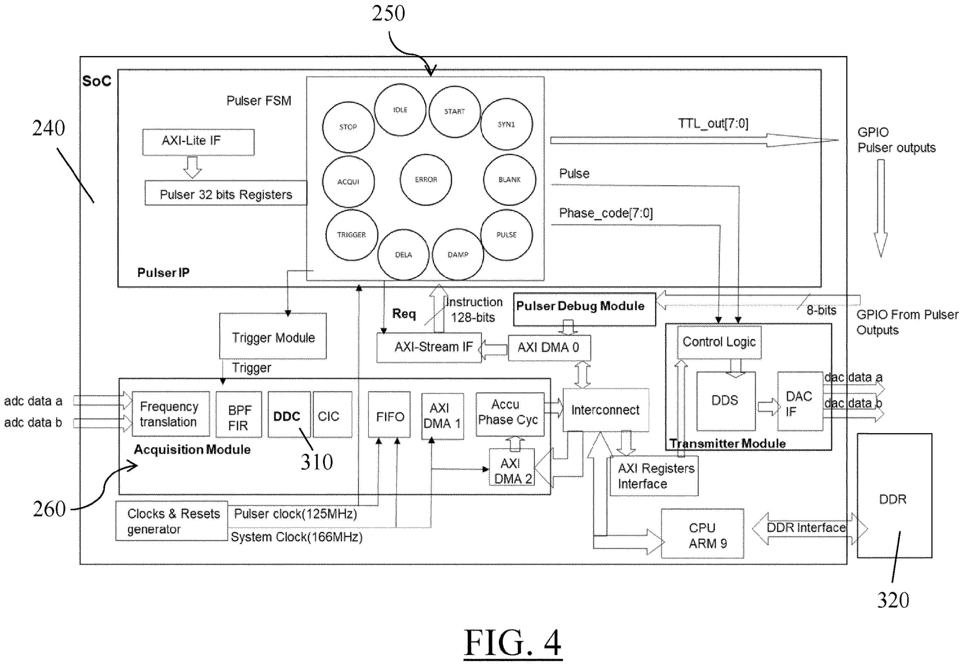

FIG. 4 illustrates the architecture of the SoC FPGA 240. Before being demodulated by the DDC 310, the processing may comprise filtering the acquired signal by a digital bandpass decimation filter with a decimation ratio of 4 and a center frequency around the intermediate frequency (IF). The objective of this filtering is to eliminate all the frequencies that are not interesting and in particular the frequency *FI* + 2 ∗ *v_{RF}* + *Δvᵢ* . In addition, it serves to lower the sampling frequency so that it is equal to 4 times the intermediate frequency. After the filtering through the digital bandpass, the processing may comprise changing the clock domain of the filtered signal from 125 MHz to Fs/4 by passing through a clock domain converter.

The processing may then comprise the demodulation (DDC), which may be coded in VHDL, and may comprise generating, from the signal having a frequency of *FI* - *Δvᵢ* , a new complex signal composed of two signals, one for the real part (Q) and the other for the imaginary part (I). At the output of the DDC, the spectral window is divided by 8. The digital demodulation in quadrature is carried out within the DDC by taking one sample out of two for each channel (real and imaginary) in a shifted way. Since the sampling frequency is 4 times that of the carrier (IF), this down-sampling is equivalent to multiplying the acquired signal of frequency *FI* - *Δvᵢ* by a sinusoid of frequency *FI,* because the values of cos(2π × *FI* × t) and sin(2π × *FI* × t) are reduced to simple integer values which are 1, 0, -1, 0 and 0, 1, 0, -1 respectively.

The DDC operates at a frequency of 31,25 MHz. At the output of the DDC, a complex signal is obtained in base band. The frequency of the complex signal is *-Δvᵢ* . The data at the output of the DDC are in the 31,25 MHz clock domain. The processing comprises a conversion of clock domain from 31,25 MHz to 15,625 MHz on the I and Q data from the DDC.

Then, to further reduce the spectral window and decrease the number of points, the processing may comprise a CIC decimation of the demodulated complex signal whose frequency is *-Δvᵢ* to undergo a decimation with a variable high ratio from 4 to 1024 and programmable by software (e.g., the Linux application of the acquisition) (for example 128). The final spectral window obtained, in this example, is equal to the initial value (125 MHz) divided by a ratio of 1024 which is 8 × 128. The final spectral window is therefore 125 MHz/1024 = 122070 Hz, which allows to display peaks with offsets *Δvᵢ* (the difference between the frequency of the excitation and the resonance frequency of the nuclei of the studied material) between -61035 Hz and +61035 Hz.

The CIC filters operate at a frequency of 15,625 MHz. At the output of the CIC, the processing may comprise a clock domain conversion of the I/Q data (after being decimated) from 15,625 MHz to 166 MHz using a FIFO and sending of the converted data to the DMA. The DMA may then send this decimated FID to the external DDR memory 320.

The FPGA 240 is configured to read the acquired FID, corresponding to the current scan, and to accumulate it with the previous scans with a phase cycling (e.g., chosen by the user). Then, the FPGA 240 may be configured to send the accumulated FID to the post-processing station to be displayed on the fly by the interfacing software. At the end of the manipulation, and after having performed the number of accumulations corresponding to the number of scans programmed by the user, the FPGA 240 is configured to store the FID in the form of a binary file which contains the two channels I and Q of the NMR/NQR signal.

In examples, the NQR spectrometer also perform in a "bypass" mode. In that case, the NQR spectrometer directly writes the acquired signal in the external DDR memory without going through the filtering, DDC and/or CIC signal processing.

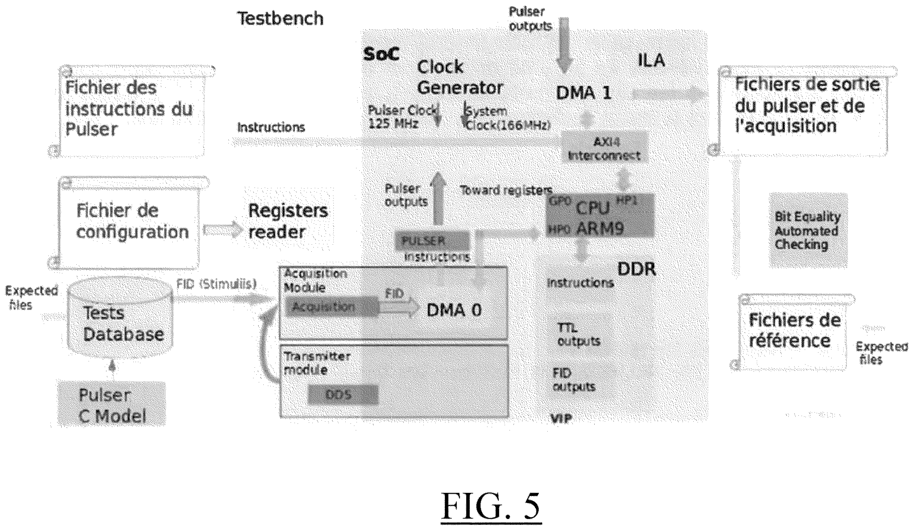

FIG. 5 illustrates an example of test environment of the SoC FPGA. First, the functioning of the FPGA was simulated in an RTL (Register Transfer Level) testbench written in System/Verilog language. A rigorous verification methodology acquired through expertise in the semiconductor industry was adopted. In this verification environment the DUT (Device Under Test) is the SoC (System On Chip) in question. This testbench is used to simulate the operation of the VHDL/Verilog model of the various FPGA blocks and modules that make up the SoC (Acquisition, Emission or Pulser). This first test step, which is the simulation, is called functional or behavioral verification. Its purpose is to validate the functionality of the VHDL/Verilog models of the electronic circuits which will be translated in fine in the form of logic gates and electronic components on the final real circuit which is in our case the FPGA.

In addition to functional verification and hardware debug and validation, another target validation has also been developed using Xilinx probes integrated in the system called ILA (Integrated Logic analyzer). These ILA blocks (see FIG. 5) are used to monitor the internal signals of the design using the design using the Xilinx Hardware Manager tool. A validation of the system was also carried out by using the two probes of the oscilloscope (digital and analog) to check the shape and behavior of the output signals. The acquisition was also tested by detecting the outputs from a frequency generator.

In addition, the NQR spectrometer has been tested on a real sample of Sodium Nitrite. In this test, the NQR spectrometer has been used on a real sample of Sodium nitrite using the following parameters: 32 scans, d1 = 0.5 S, experiment time = 16.77 S, number of points before decimation = 1048576 (1 Million points) and decimation ratio = 1024. FIG. 6 shows the result of this test performed with the NQR spectrometer. The frequency of the displayed signal at 4.646 MHz is clearly detected. The result includes a graph 510 showing the offset 520 (Δvₓ) that may be displayed. For example, the NQR spectrometer may comprise a screen and may be configured to display this graph 510. Alternatively or additionally, the NQR spectrometer may send the accumulated FIDs to a post-processing unit, which may comprise a display and may display this graph 510. The user may then read the offset 520 (Δvₓ) on that displayed graph 510, and obtain structural information from the studied material from the value of this offset 520 (Δvₓ).

### Details of the accumulation procedure

The accumulation is now discussed in more details.

The FID accumulation coupled with pulse phase cycling allows enhancing the Signal to Noise Ratio. The FID accumulation coupled with pulse phase cycling comprises accumulating or averaging several FIDs (Free Induction Decay) called scans with special changes of pulse phases so as to add the wanted signal coherently and to cancel unwanted artifacts. The FID accumulation coupled with pulse phase cycling may be performed "on the fly" by the FPGA to speed up computation and data transfer. During acquisition, the phase cycling technique (e.g., CYCLOPS) comprises, depending on the current cycling step (+x, +y, -x or -y), summing or subtracting the real and imaginary parts of the new received FID to/from the real or imaginary parts of the already accumulated FID. The result of these operations give the real and imaginary components of the new accumulated FID. Depending on the relative phase cycle of the receiver and the excitation pulses, the procedure results in the successive adding of the selected information and the selective canceling of unwanted signal or artifacts (e.g., correction of DC imbalance).

Within the SoC FPGA, a Write FIFO and an AXI DMA write channel receive the current processed FID and store it inside the external DDR. Each acquisition point in the FID is composed of two 32-bits components, a real and an imaginary part. The FPGA implements a feedback loop: before storing the received FID real and imaginary parts inside the DDR, the FPGA sums it or subtracts it with/from the read real and imaginary parts of the already accumulated FID stored in the DDR. The read path, that fetches the previous accumulated FID, is formed by an AXI DMA read channel and a read FIFO.

In order to maintain synchronization between the new received FID and the accumulated one stored in the DDR, the FPGA implements a combinatorial logic so as to monitor and control the different handshake signals, i.e., VALID and READY, of the write FIFO, the Write DMA, the read FIFO, and the read DMA . Typically, during an experiment with several scans and a certain phase cycling, during each scan, the FPGA sums or subtracts each point of the new coming FID with the corresponding point of the previous accumulated FID that is read from a DDR zone before being stored again using the write FIFO and DMA in the same DDR zone. Overlapping between read and written FID is prevented by construction since, in the FPGA architecture, the read operation is performed by DMA bursts from memory and summation/subtraction are performed, almost at the acquisition pace, point by point at the outputs of the FIFOs (Write FIFO and Read FIFO)

### Details of the very large band acquisition procedure

The very large band acquisition is now discussed in more details.

The SoC architecture of the FPGA based spectrometer enables direct digital acquisition in very large band mode, e.g., with detected frequencies ranges up to 62.5 MHz. Thanks to the high speed of the nowadays available ADCs, the NQR spectrometers may perform direct detection without the demodulation. In addition, thanks to the fact that the NQR spectrometer uses external DDR for FID storage, the NQR spectrometer may afford handling huge FIDs that may reach 1 million points by either applying very low decimation factors or not decimating at all.

For this purpose, the FPGA of the NQR spectrometer may implement a bypass path (without filtering nor decimation) for the acquired FID that contains only a clock domain converter, a write FIFO, a data width converter and an AXI write DMA. The acquired FID is hence stored in the external DDR without any demodulation or decimation. In this case the obtained spectrum width can be very large, e.g., up to 62.5 MHz with the current board. In that case, the FPGA may also perform processing of the acquired signal such as decimation (e.g., with small decimation ratios) or filtering. The NQR spectrometer may implement this mode when coupled with an ultra large band front-end (Probe and duplexers) that enables very fluid and easy spectrum scanning for frequencies search. It allows performing measurements with continuous tuning and matching of the probe. Indeed, in this mode, the NQR spectrometer can detect all the available resonance frequencies of all studied nuclei in a single shot.

## Claims

1. A Nuclear Quadrupole Resonance (NQR) spectrometer comprising a System on Chip (SoC) Field Programmable Gate Arrays (FPGA) (240) communicatively coupled to an external memory (320), the SoC FPGA (240) being configured to perform the functions of:
- a pulse programmer (250) for producing one or more pulse sequences, the pulse programmer being configured for reading, sequentially, instructions stored on the external memory; and
- an acquisition module (260) for processing an acquired analog response signal (FID) emitted by nuclei of a material to be studied, the acquired analog response signal containing one or more frequencies each including a respective offset *Δvᵢ* with respect to the RF excitation pulse, and for recording the processed signal on the external memory.

2. The NQR spectrometer of claim 1, wherein the processing of the acquired analog response signal comprises filtering, denoising and/or decimating the acquired analog response signal.

3. The NQR spectrometer of claim 2 or 3, wherein the SoC FPGA (240) is configured to repeat the execution of the functions of the pulse programmer (250) and of the acquisition module (260) cyclically, each repetition of the recording of the processed signal comprising:
- retrieving one or more previously accumulated FIDs that have been stored temporarily in the external memory;
- accumulating the processed signal with the retrieved one or more previously accumulated FIDs; and
- storing the result of the accumulation in the external memory.

4. The NQR spectrometer of claim 3, wherein the produced pulse sequences have phases, the phases of the produced pulse sequences varying cyclically at each repetition, the accumulating of the processed signal with the one or more previously accumulated FIDs comprising a subtraction or an addition of the processed signal with the one or more previously accumulated FIDs according to the phase variation.

5. The NQR spectrometer of claim 3 or 4, wherein the NQR spectrometer is configured to, after each repetition, send the result of the accumulation to a post-processing unit.

6. The NQR spectrometer of any one of claims 3 to 5, wherein the NQR spectrometer is configured to send the result of the last accumulation performed at the end of an experiment to a post-processing unit.

7. The NQR spectrometer of any one of claims 1 to 6, wherein the SoC FPGA (240) is further configured to perform the function of:
- a Direct Digital Synthesizer (DDS) for generating the RF excitation pulses that stimulates the nuclei of the material to be studied.

8. The NQR spectrometer of any one of claims 1 to 7, wherein the pulse programmer has a pulse width resolution equal to or larger than 8 nanoseconds.

9. The NQR spectrometer of any one of claims 1 to 8, wherein the external memory (320) is a DDR memory.

10. The NQR spectrometer of any one of claims 1 to 9, wherein the external memory (320) has a storage capacity equal to or larger than 1 gigabit.

11. The NQR spectrometer of any one of claims 1 to 10, wherein the instructions are current experiment related 128-bits coded instructions words, the instructions being stored on a dedicated zone of the external memory (320).

12. The NQR spectrometer of any one of claims 1 to 11, wherein the processing of the acquired analog response signal further includes:
- digital frequency shifting the acquired analog response signal by digitally multiplying the acquired analog response signal by an RF signal so as to obtain a signal centered around a fixed intermediate carrier frequency (IF) containing one or more frequencies with the one or more offsets equal to *Δvᵢ* after digital band-pass filtering;
- digitally down converting (310) the centered signal so as to obtain a complex demodulated signal having one or more frequencies corresponding to the one or more offsets *Δvᵢ*.

13. The NQR spectrometer of any one of claims 1 to 12, wherein the spectrometer is coupled to an ultra-broad band probe, with a detection spectral width equal to an initial spectral width before decimation corresponding to an interval [0, F,/2], wherein Fₛ is a sampling frequency of the analog-to-digital conversion.

14. A computer program comprising instructions which, when the program is executed by a NQR spectrometer according to any one of claims 1 to 13, cause the NQR spectrometer to carry out the functions of the pulse programmer (250).
